# FASCICULE DE BREVET EUROPEEN

(11) **EP 0 554 848 B1**
(45) Date de publication et mention de la délivrance du brevet: **23.04.1997**
(21) Numéro de dépôt: 93101637.2
(22) Date de dépôt: 03.02.1993
(51) Int. Cl.: H01L 41/04

(54) **Dispositif comportant un transducteur piézo-électrique**
Einrichtung mit einem piezoelektrischen Wandler
Device comprising a piezoelectric transducer

(30) Priorité: 06.02.1992 FR 9201437
(43) Date de publication de la demande: 11.08.1993
(73) Titulaire: ASULAB S.A., CH-2501 Bienne (CH)
(72) Inventeur: Fridolin, Wiget, CH-2000 Neuchâtel (CH)
(74) Mandataire: de Montmollin, Henri

(56) Documents cités:
- FR-A- 2 329 445
- US-A- 5 036 263

## Description

La présente invention a pour objet un dispositif comportant un transducteur piézo-électrique, une source d'alimentation en énergie électrique produisant une première tension et des moyens de commande répondant à un premier état d'un signal de commande pour appliquer audit transducteur une tension de commande continue et à un deuxième état dudit signal de commande pour court-circuiter ledit transducteur, lesdits moyens de commande comportant des moyens élévateurs de tension répondant à ladite première tension pour produire ladite tension de commande continue et comportant une bobine, une diode et un condensateur branchés en série, dans cet ordre, entre les bornes de ladite source d'alimentation, et des moyens pour établir et supprimer alternativement un court-circuit aux bornes du circuit formé par ladite diode et ledit condensateur.

On utilise très souvent un transducteur piézo-électrique pour provoquer un déplacement d'un élément mécanique sur une distance faible et bien déterminée en réponse à un signal de commande, voir par exemple le document US-A-5 036 263.

Il n'est pas possible de mentionner ici tous les éléments mécaniques qui peuvent être ainsi déplacés. On mentionnera simplement, à titre d'exemple non limitatif, la membrane d'une micro-pompe destinée à injecter un médicament à un patient avec un débit très faible et très bien déterminé, ou le porte-outil d'une machine destinée à usiner une pièce avec une grande précision ou encore des buses traçantes dans les dispositifs traçants à encre en mosaïque tels que décrit dans le document FR-A-2 329 445.

Les transducteurs piézo-électriques comportent deux électrodes déposées sur un corps en un matériau piézo-électrique qui est destiné à se déformer en réponse à l'application d'une tension de commande entre ces électrodes pour entraîner le déplacement de l'élément mécanique auquel il est couplé.

La forme et les dimensions du corps en matériau piézo-électrique, la disposition des électrodes sur ce corps et la manière dont ce dernier est couplé à l'élément mécanique à déplacer ne seront pas décrites ici car elles dépendent de l'utilisation du transducteur et peuvent donc être très diverses.

La tension de commande qu'il faut appliquer à ces transducteurs pour les faire fonctionner, c'est-à-dire pour que leur corps en matériau piézo-électrique se déforme de la manière voulue, est généralement supérieure à 50 volts, et même souvent nettement supérieure à 100 volts.

Or les appareils portables équipés de tels transducteurs doivent évidemment être alimentés par une source d'alimentation autonome, qui ne peut être constituée que par des piles ou des accumulateurs rechargeables. Dans de nombreux cas, la place disponible dans ces appareils est d'ailleurs tellement limitée que cette source ne peut être constituée que par une seule pile ou un seul accumulateur rechargeable.

On voit que, dans la grande majorité des cas, la tension fournie par la source d'énergie électrique des appareils portables équipés d'un transducteur piézo-électrique est beaucoup trop basse pour faire fonctionner ce dernier. Ces appareils portables doivent donc comporter un dispositif de commande capable de produire la haute tension nécessaire au fonctionnement de ce transducteur à partir de la basse tension produite par leur source d'alimentation, et d'appliquer cette haute tension à ce transducteur lorsque celui-ci doit fonctionner.

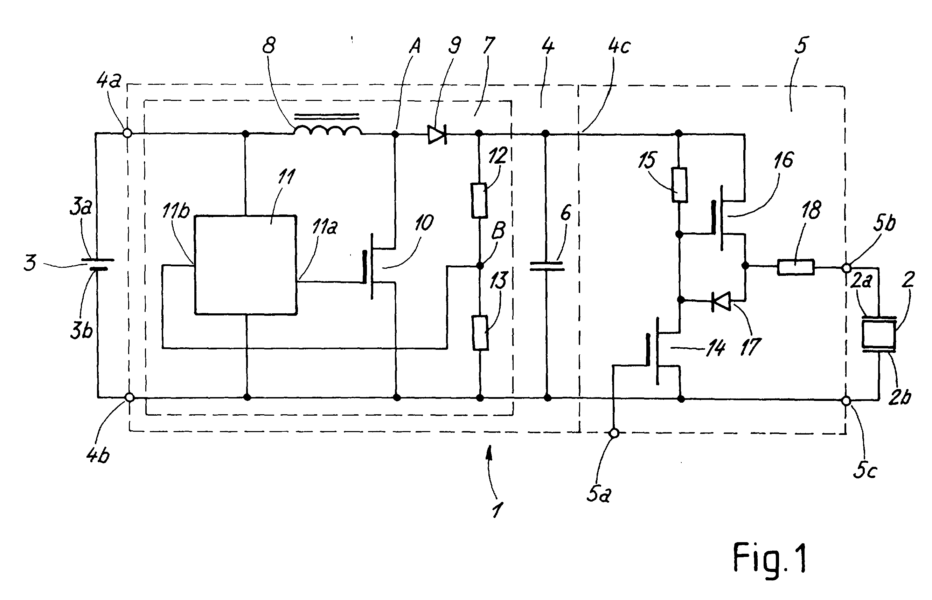

La figure 1 représente schématiquement un dispositif connu destiné à équiper un tel appareil portable.

Ce dispositif, désigné dans son ensemble par la référence 1, comporte un transducteur piézo-électrique 2, une source d'alimentation en énergie électrique 3 constituée, par exemple, par une pile fournissant une tension de l'ordre de 1,5 V, un circuit élévateur de tension 4 fournissant, à partir de cette tension relativement basse, la tension de commande élevée nécessaire au fonctionnement du transducteur 2, et un circuit commutateur 5 destiné à appliquer cette tension de commande à ce transducteur 2 ou à le court-circuiter selon qu'il doit se déformer ou non. Un tel circuit élévateur de tension 4 est connu par exemple du catalogue "1990 integrated circuits data book", Laser & Electronic Equipment (cf page 6, figure 4) de la société Maxim.

La borne positive et la borne négative de la pile 3 sont respectivement désignées par les références 3a et 3b, et on admettra dans la suite de cette description que le potentiel de cette dernière borne 3b est le potentiel de référence du dispositif 1. Toutes les tensions qui seront mentionnées ci-après seront donc des tensions mesurées par rapport à cette borne 3b.

Le circuit élévateur de tension 4 comporte deux bornes d'alimentation 4a et 4b qui sont respectivement reliées à la borne positive 3a et à la borne négative 3b de la pile 3, ainsi qu'un condensateur 6 et un circuit 7 de charge de ce condensateur 6.

Le circuit de charge 7 comporte une bobine 8 et une diode 9 branchées en série, dans cet ordre, entre la borne 4a et l'une des bornes du condensateur 6, l'autre borne de ce dernier étant reliée à la borne 4b.

Le circuit de charge 7 comporte également un transistor MOS 10 dont la source et le drain sont respectivement reliés à la borne d'alimentation 4b et au point de liaison A de la bobine 8 et de la diode 9. Le canal de ce transistor 10 est donc branché en parallèle avec le circuit formé par la diode 9 et le condensateur 6.

L'électrode de commande du transistor 10 est reliée à la sortie 11a d'un circuit oscillateur 11 qui est alimenté par la pile 3 et qui comporte une entrée de commande 11b dont le rôle sera décrit plus loin.

Cette entrée de commande 11b est reliée au point commun B de deux résistances 12 et 13 branchées en série l'une avec l'autre et formant un diviseur de tension connecté en parallèle avec le condensateur 6.

Le circuit oscillateur 11 comporte une source de tension de référence, non représentée séparément, qui fournit une tension Ur, et il est agencé de manière que, lorsque son entrée 11b est à une tension inférieure à cette tension Ur, sa sortie 11a fournit un signal périodique qui rend le transistor 10 alternativement conducteur et bloqué, et que lorsque son entrée 11b est à une tension supérieure à cette tension Ur, sa sortie 11a fournit un signal continu qui bloque en permanence le transistor 10. Ce circuit oscillateur 11 est bien connu des spécialistes et ne sera donc pas décrit plus en détail ici.

Les valeurs des résistances 12 et 13 sont choisies de manière que la tension Ub au point B, qui est également la tension de l'entrée 11b de l'oscillateur 11, soit égale à la tension de référence Ur mentionnée ci-dessus lorsque la tension Uc aux bornes du condensateur 6, qui est également la tension que le circuit 4 fournit à sa sortie 4a, est égale à la tension de commande Ut nécessaire au fonctionnement du transducteur 2.

Ainsi, tant que la tension Uc est inférieure à la tension de commande Ut, la tension Ub est inférieure à la tension de référence Ur, et le transistor 10 est mis alternativement dans son état conducteur et son état bloqué par le signal fourni par la sortie 11a de l'oscillateur 11.

Tant que le transistor 10 est conducteur, il laisse passer un courant de la borne 3a à la borne 3b de la pile 3 à travers la bobine 8.

Chaque fois que ce transistor 10 se bloque, ce courant est dévié à travers la diode 9 vers le condensateur 6 et charge ce dernier, grâce au fait que la tension au point A augmente alors jusqu'à ce qu'elle dépasse la tension Uc.

Cette tension Uc augmente donc progressivement jusqu'à ce qu'elle dépasse la tension Ut, ce qui a comme conséquence que la tension Ub devient supérieure à la tension Ur. L'oscillateur 11 cesse alors de fonctionner et le transistor 10 se bloque.

Cette situation reste inchangée jusqu'à ce que le condensateur 6 se décharge et que la tension Uc redevienne inférieure à la tension Ut, ce qui a comme conséquence que la tension Ub redevient inférieure à la tension Ur.

L'oscillateur 11 recommence alors à fonctionner, et le condensateur 6 est à nouveau chargé comme cela a été décrit ci-dessus.

La tension Uc est donc en permanence sensiblement égale à la tension de commande Ut, les caractéristiques des divers composants du circuit 4, notamment la fréquence du signal périodique fourni par la sortie 11a de l'oscillateur 11 lorsque celui-ci fonctionne et l'hystérèse du circuit qui, dans cet oscillateur 11, compare la tension Ub à la tension de référence Ur, étant choisies de manière que la différence entre ces tensions Uc et Ut soit toujours faible.

Le circuit commutateur 5, qui est destiné à appliquer au transducteur 2 la tension Uc produite par le circuit élévateur de tension 4 de la manière qui vient d'être décrite, comporte un transistor MOS 14 dont la source est reliée à la borne négative 3b de la pile 3 et dont le drain est relié à la sortie 4c du circuit élévateur de tension par l'intermédiaire d'une résistance 15. L'électrode de commande de ce transistor 14 est reliée à une borne 5a destinée à recevoir un signal de commande qui sera décrit plus loin.

Le circuit 5 comporte encore un autre transistor MOS 16 dont le drain est relié directement à la sortie 4c du circuit 4 et dont la source est reliée, d'une part, au drain du transistor 14 par l'intermédiaire d'une diode 17 et, d'autre part, à une borne de sortie 5b par l'intermédiaire d'une résistance 18. L'électrode de commande de ce transistor 16 est reliée au drain du transistor 14.

Une des électrodes du transducteur 2, désignée par 2a, est reliée à la borne de sortie 5b mentionnée ci-dessus, et l'autre électrode de ce transducteur 2, désignée par 2b, est reliée à une deuxième borne de sortie, 5c, qui est elle-même reliée à la borne négative 3b de la pile 3. Cette deuxième borne de sortie 5c peut d'ailleurs ne pas exister, la deuxième électrode 2b du transducteur 2 pouvant alors être reliée, par exemple, directement à la borne 3b de la pile 3.

Le circuit qui applique à la borne 5a du circuit commutateur 5 le signal de commande mentionné ci-dessus n'a pas été représenté, car sa structure dépend de la nature de l'appareil dont fait partie le dispositif 1. On notera simplement que, quelle que soit sa structure, ce circuit est agencé de manière que ce signal de commande prend sélectivement un premier état dans lequel il provoque le blocage du transistor 14 et un deuxième état dans lequel il rend ce transistor 14 conducteur.

Dans l'exemple de la figure 1, ce signal de commande peut être au potentiel de la borne négative 3b de la pile 3 lorsqu'il est dans son premier état et au potentiel de la borne positive 3a de la pile 3 lorsqu'il est dans son deuxième état.

On voit facilement que lorsque ce signal de commande est dans son premier état et que le transistor 14 est bloqué, le transistor 16 est conducteur. La tension Uc produite par le circuit élévateur de tension 4 est ainsi appliquée entre les électrodes 2a et 2b du transducteur 2, ce qui provoque la déformation désirée du corps en matériau piézo-électrique de ce transducteur 2 et le déplacement de l'organe mécanique qui lui est relié.

On voit également facilement que, lorsque le signal de commande appliqué à l'entrée 5a du circuit commutateur 5 est dans son deuxième état et que le transistor 14 est conducteur, le transistor 16 est bloqué. Le transducteur 2 est donc déconnecté du circuit élévateur de tension 4, et ses électrodes 2a et 2b sont pratiquement court-circuitées. circuitées. Ce transducteur 2 est donc dans son état de repos.

La diode 17 sert uniquement à améliorer le blocage du transistor 16 lorsque le transistor 14 est conducteur, et la résistance 18 sert à limiter le courant qui traverse soit le transistor 16 à l'instant où ce dernier est rendu conducteur, soit le transistor 14, également à l'instant où ce dernier est rendu conducteur.

Le condensateur 6 du circuit élévateur de tension 4 a généralement une capacité assez élevée, de l'ordre de quelques microfarads. En outre, ce condensateur 6 doit évidemment supporter la haute tension produite par ce circuit 4. Il en découle que ce condensateur 6 est un composant assez volumineux qu'il est difficile, voire même parfois impossible, de loger dans l'appareil comprenant le dispositif 1 lorsque cet appareil doit être portable et qu'il doit avoir de très faibles dimensions. En outre, ce condensateur 6 est un composant assez cher dont le prix influence défavorablement le prix de revient des dispositifs connus tel que le dispositif 1 de la figure 1.

En outre, les transistors 14 et 16 doivent également supporter la haute tension produite par le circuit 4 et sont donc aussi des éléments chers dont le prix influence défavorablement le prix de revient des dispositifs connus tels que le dispositif de la figure 1.

D'autre part, le diviseur de tension formé par les résistances 12 et 13 dissipe une quantité assez élevée d'énergie électrique du fait que la haute tension produite par le circuit 4 lui est appliquée en permanence.

Cette énergie électrique dissipée par ce diviseur de tension doit évidemment être fournie par la pile 3, au détriment de la durée de vie de celle-ci.

Un but de la présente invention est de proposer un dispositif remplissant les mêmes fonctions que le dispositif connu qui vient d'être décrit à l'aide de la figure 1, mais qui ne présente pas les inconvénients de celui-ci, c'est-à-dire qui a, toutes autres choses étant égales, un encombrement, un prix de revient et une consommation d'énergie électrique inférieurs à ceux de ce dispositif connu.

Ce but est atteint grâce au fait que le dispositif de la présente invention, qui comporte un transducteur piézo-électrique, une source d'alimentation en énergie électrique produisant une première tension et des moyens de commande répondant à un premier état d'un signal de commande pour appliquer audit transducteur une tension de commande continue et à un deuxième état dudit signal de commande pour court-circuiter ledit transducteur, lesdits moyens de commande comportant des moyens élévateurs de tension répondant à ladite première tension pour produire ladite tension de commande continue et comportant une bobine, une diode et un condensateur branchés en série, dans cet ordre, entre les bornes de ladite source d'alimentation, et des moyens pour établir et supprimer alternativement un court-circuit aux bornes du circuit formé par ladite diode et ledit condensateur, est caractérisé par le fait que ledit condensateur est constitué par ledit transducteur, et que lesdits moyens élévateurs de tension répondent en outre audit premier état dudit signal de commande pour produire ladite tension de commande continue.

Grâce au fait que le condensateur faisant partie des moyens élévateurs de tension est constitué par le transducteur lui-même, le dispositif selon l'invention a un encombrement et un prix de revient inférieurs à ceux du dispositif connu décrit ci-dessus à l'aide de la figure 1, puisqu'il ne comporte aucun condensateur semblable au condensateur 6 de ce dernier dispositif. En outre, grâce au fait que les moyens élévateurs de tension répondent au premier état du signal de commande pour produire la tension d'alimentation du transducteur, cette tension n'est pas produite en permanence, ce qui réduit la dissipation d'énergie électrique par le diviseur de tension qu'ils comportent et qui est semblable au diviseur de tension formé par les résistances 12 et 13 du circuit 4 de la figure 1, comme cela sera montré plus loin.

D'autres buts et avantages du dispositif de la présente invention seront rendus évidents par la description d'une de ses formes d'exécution qui va être faite à l'aide du dessin annexé dans lequel :
- la figure 1, déjà mentionnée, représente le schéma-bloc d'un dispositif de l'art antérieur; et
- la figure 2 représente le schéma-bloc d'une forme d'exécution du dispositif selon l'invention.

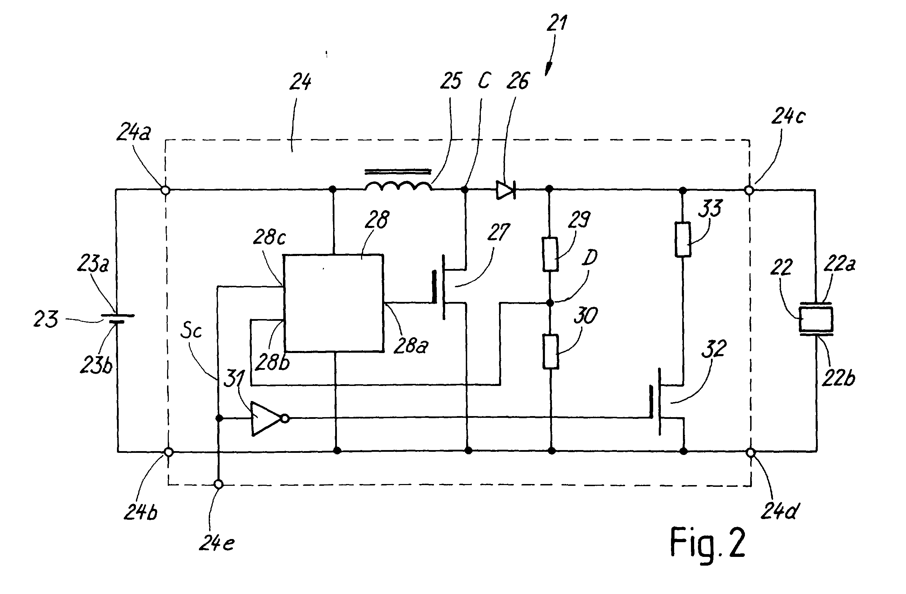

Le dispositif selon l'invention représenté schématiquement et à titre d'exemple non limitatif à la figure 2 est désigné dans son ensemble par la référence 21.

Ce dispositif 21 comporte un transducteur 22 ayant un corps en un matériau piézo-électrique qui n'a été représenté que schématiquement et qui est destiné à se déformer de manière déterminée en réponse à l'application, entre des électrodes disposées sur ce corps et désignées par les références 22a et 22b, d'une tension également déterminée, qui sera appelée tension Ut dans la suite de cette description.

La déformation du corps en matériau piézo-électrique du transducteur 22 est destinée à déplacer un élément mécanique d'une distance faible et bien déterminée. Cet élément mécanique et sa liaison avec ce corps du transducteur 22 n'ont pas été représentés.

Le dispositif 21 comporte encore une source d'alimentation en énergie électrique 23 qui peut être, par exemple, une pile fournissant une tension de l'ordre de 1,5 V. Il sera d'ailleurs rendu évident par la suite de cette description que la valeur de cette tension ne joue pratiquement aucun rôle dans la présente invention et que cette valeur peut être quelconque.

Les bornes positive et négative de la source 23 sont respectivement désignées par les références 23a et 23b et le potentiel de cette dernière borne 23b sera considéré dans la suite de cette description comme étant le potentiel de référence du dispositif 21, de sorte que toutes les tensions qui seront mentionnées ci-après seront des tensions mesurées par rapport à cette borne 23b.

Le dispositif 21 comporte encore un circuit de commande 24 du transducteur 22, qui a deux bornes d'alimentation 24a et 24b reliées respectivement aux bornes 23a et 23b de la source 23, deux bornes de sortie 24c et 24d reliées respectivement aux électrodes 22a et 22b du transducteur 22, et une borne d'entrée 24e dont le rôle sera décrit plus loin.

Le borne de sortie 24d, qui est reliée dans cet exemple à la borne d'alimentation 24b, peut d'ailleurs ne pas exister, l'électrode 22b du transducteur 22 pouvant alors être reliée directement à la borne 23b de la source 23.

Le circuit de commande 24 comporte une bobine 25 et une diode 26 branchées en série, dans cet ordre, entre les bornes 24a et 24c, ainsi qu'un transistor MOS 27 de type n dont la source et le drain sont respectivement reliés à la borne d'alimentation 24b et au point de liaison de la bobine 25 et de la diode 26, désigné par la référence C.

L'électrode de commande du transistor 27 est reliée à la sortie 28a d'un circuit oscillateur 28 qui est alimenté par la source 23 et qui comporte deux entrées de commande 28b et 28c dont le rôle sera décrit plus loin.

L'entrée de commande 28b de l'oscillateur 28 est reliée au point commun D de deux résistances 29 et 30 branchées en série l'une avec l'autre entre les bornes 24c et 24d et formant donc un diviseur de tension branché en parallèle avec le transducteur 22.

L'entrée de commande 28c de l'oscillateur 28 est reliée à la borne 24e du circuit 24 et à l'entrée d'un inverseur 31 dont la sortie est reliée à l'électrode de commande d'un transistor MOS 32 de type n. La source et le drain de ce transistor 32 sont respectivement reliés à la borne 24d et, par l'intermédiaire d'une résistance 33, à la borne 24c. Le circuit formé par le canal du transistor 32 et la résistance 33 est donc également en parallèle avec le transducteur 22.

Dans la description du fonctionnement du dispositif 21 qui va suivre, et en accord avec une convention qui est généralement admise, on qualifiera l'état des divers signaux qui seront mentionnés d'état logique "0" ou d'état logique "1" selon que la tension de ces signaux sera nulle, ou au moins proche de zéro, ou respectivement proche de la tension de la borne 24a, c'est-à-dire de la tension fournie par la source d'alimentation 23.

Les transistors 27 et 32 étant de type n et leur source étant reliée à la borne 24b du circuit 24, on voit qu'ils sont bloqués ou conducteurs selon que le signal appliqué à leur électrode de commande est à l'état logique "0" ou "1".

Comme le circuit 11 de la figure 1, le circuit oscillateur 28 comporte une source de tension de référence, également non représentée séparément, fournissant une tension constante qui sera également appelée tension Ur. Ce circuit oscillateur 28 est agencé de manière que le signal fourni par sa sortie 28a, qui sera appelé signal 28a dans la suite de cette description, prend alternativement les états logiques "0" et "1" lorsque son entrée 28b est à une tension inférieure à la tension Ur définie ci-dessus et que, simultanément, son entrée 28c est à l'état logique "1". Le circuit oscillateur 28 est en outre agencé de manière que ce signal 28a est en permanence à l'état logique "0" lorsque son entrée 28b est à une tension supérieure à la tension Ur ou lorsque son entrée 28c est à l'état logique "0". Ce circuit oscillateur 28 ne sera pas décrit plus en détail car sa réalisation, qui peut être faite de diverses manières, ne pose aucun problème à l'homme du métier.

Les valeurs des résistances 29 et 30 sont choisies de manière que la tension de leur point commun D, qui sera appelée tension Ud, soit égale à la tension Ur mentionnée ci-dessus lorsque la tension aux bornes du diviseur de tension qu'elles forment, qui sera appelée tension Us, est égale à la tension Ut définie ci-dessus. Les tensions Ud et Us sont évidemment aussi celles qui sont respectivement appliquées à l'entrée 28b de l'oscillateur 28 et aux électrodes 22a et 22b du transducteur 22.

L'entrée 24e du circuit 24 est reliée à un circuit de commande qui lui applique un signal de commande Sc et qui est agencé de manière que ce signal Sc est à l'état logique "1" ou "0" selon que le transducteur 22 doit être soumis à la tension Ut ou non. Ce circuit n'a pas été représenté car sa structure dépend de la nature de l'appareil dont fait partie le dispositif 21.

On voit facilement que lorsque le signal Sc est à l'état logique "0", le transistor 32, dont l'électrode de commande est alors à l'état logique "1", est conducteur. La tension Us est donc nulle, et le transducteur 22 est dans son état non déformé.

La tension Ud est donc également nulle et donc inférieure à la tension Ur définie ci-dessus. Mais le signal 28a reste cependant en permanence à l'état logique "0" puisque le signal Sc est à l'état logique "0". Le transistor 27 est donc bloqué.

Lorsque le signal Sc passe à l'état logique "1", le transistor 32 se bloque puisque son électrode de commande passe alors à l'état logique "0".

En outre, le signal 28a commence à osciller entre les états logiques "0" et "1" puisque, à cet instant, la tension Ud est encore nulle et donc inférieure à la tension Ur et que le signal Sc est à l'état logique "1".

Lorsque ce signal 28a est à l'état logique "1", le transistor 27 conduit et laisse passer un courant de la borne 23a à la borne 23b de la pile 23, à travers la bobine 25.

Lorsque ce signal 28a est à l'état logique "0", le transistor 27 se bloque, et le courant mentionné ci-dessus est dévié à travers la diode 26 vers le transducteur 22.

Ce transducteur 22 forme un condensateur dont les plaques sont constituées par les électrodes 22a et 22b, et dont le diélectrique est constitué par le corps en matériau piézo-électrique de ce transducteur 22.

Ce condensateur est chargé par le courant qui traverse la diode 26 chaque fois que le transistor 27 se bloque, de sorte que la tension Us commence à augmenter.

Après quelques périodes du signal 28a, cette tension Us atteint et dépasse la valeur Ut, et le transducteur 22 prend son état déformé. Au même moment, la tension Ud atteint et dépasse la tension Ur, et le signal 28a prend l'état logique "0", ce qui bloque le transistor 27.

Cette situation reste inchangée jusqu'à ce que la tension Us redescende en dessous de la valeur Ut et que la tension Ud redevienne donc inférieure à la tension Ut.

Dès cet instant, le signal 28a recommence à prendre alternativement les états logiques "1" et "0", et la tension Us recommence à augmenter, avec les mêmes conséquences que ci-dessus.

Les caractéristiques des divers composants du circuit 21, notamment l'hystérèse du circuit qui, dans l'oscillateur 28, compare la tension Ud à la tension Ur, ainsi que la fréquence du signal 28a lorsque celui-ci oscille entre les états logiques "0" et "1", sont évidemment choisies de manière que la différence entre les tensions Us et Ut reste toujours faible après que ces deux tensions sont devenues égales pour la première fois.

Tant que le signal 24e est à l'état logique "1", le transducteur 22 est donc soumis à une tension sensiblement égale à la tension Ut et se trouve dans son état déformé.

Lorsque ce signal 24e prend à nouveau l'état logique "0", le signal 28a prend également l'état logique "0", et le transistor 32 devient à nouveau conducteur. La tension Us devient donc à nouveau nulle puisque le condensateur formé par le transducteur 22 est court-circuité. Ce transducteur 22 reprend donc son état non déformé.

La capacité du condensateur formé par le transducteur 22 est généralement très faible. Il est donc facile de choisir les caractéristiques des divers composants du circuit 24 de manière que les variations de la tension Us soient très rapides lorsque le signal 24e passe de l'un à l'autre de ses états logiques. Le temps de réaction du dispositif 21, c'est-à-dire le temps qui s'écoule entre chaque changement d'état du signal 24e et le changement correspondant de l'état du transducteur 22, peut donc être aussi court que celui du dispositif connu représenté par la figure 1, malgré le fait que, dans ce dispositif 21, la haute tension nécessaire au fonctionnement du transducteur 22 n'est pas produite en permanence.

On voit que le dispositif selon la présente invention est nettement plus simple que les dispositifs connus tels que le dispositif 1 de la figure 1, du fait qu'il ne comporte pas de condensateur de grande capacité tel que le condensateur 6 de la figure 1, et qu'il ne comporte pas de circuit destiné à appliquer au transducteur la haute tension nécessaire à son fonctionnement tel que le circuit formé par le transistor 16, la diode 17 et la résistance 15 du dispositif de la figure 1.

L'absence de ces composants, notamment de ce condensateur et de ce transistor qui sont des composants chers, a évidemment pour effet que, toutes autres choses étant égales, le prix de revient du dispositif selon l'invention est plus bas que celui des dispositifs connus.

De plus, l'absence du condensateur tel que le condensateur 6 de la figure 1 qui est un composant assez volumineux a comme effet que, toutes autres choses étant égales, l'encombrement d'un dispositif selon l'invention est inférieur à celui d'un dispositif connu.

En outre, dans le dispositif selon l'invention, la haute tension nécessaire au fonctionnement du transducteur n'est produite que lorsque ce dernier doit prendre son état déformé.

L'énergie électrique dissipée par le diviseur de tension formé, dans l'exemple de la figure 2, par les résistances 29 et 30, est donc nettement inférieure à celle qui est dissipée par le diviseur de tension correspondant des dispositifs connus, c'est-à-dire celui qui est formé par les résistances 12 et 13 dans l'exemple de la figure 1.

Il en découle que, toutes autres choses étant égales, la durée de vie de la pile d'alimentation du dispositif selon l'invention est nettement plus grande que celle de la pile d'alimentation d'un dispositif connu.

## Revendications

1. Dispositif comportant un transducteur piézo-électrique (22), une source d'alimentation en énergie électrique (23) produisant une première tension et des moyens de commande répondant à un premier état d'un signal de commande (Sc) pour appliquer audit transducteur (22) une tension de commande continue et à un deuxième état dudit signal de commande (Sc) pour court-circuiter ledit transducteur (22), lesdits moyens de commande comportant des moyens élévateurs de tension répondant à ladite première tension pour produire ladite tension de commande continue et comportant une bobine (25), une diode (26) et un condensateur branchés en série, dans cet ordre, entre les bornes (23a, 23b) de ladite source d'alimentation (23), et des moyens (27, 28) pour établir et supprimer alternativement un court-circuit aux bornes du circuit formé par ladite diode (26) et ledit condensateur, caractérisé par le fait que ledit condensateur est constitué par ledit transducteur (22), et que lesdits moyens élévateurs de tension répondent en outre audit premier état dudit signal de commande (Sc) pour produire ladite tension de commande continue.

2. Dispositif selon la revendication 1, caractérisé par le fait que lesdits moyens élévateurs de tension comportent en outre :
- des moyens oscillateurs (28) répondant audit signal de commande (Sc) et à ladite tension de commande pour produire un signal de sortie ayant alternativement un premier et deuxième état lorsque ledit signal de commande (Sc) est dans son premier état et que ladite tension de commande est inférieure à une tension de référence et restant en permanence dans son deuxième état lorsque ledit signal de commande est dans son deuxième état ou que ladite tension de commande est supérieure à ladite tension de référence; et
- un transistor (27) ayant un canal relié en parallèle avec ledit circuit formé par ladite diode (26) et ledit condensateur et répondant au premier état dudit signal de sortie pour établir ledit court-circuit et au deuxième état dudit signal de sortie pour supprimer ledit court-circuit.

3. Dispositif selon la revendication 1, caractérisé par le fait que lesdits moyens de commande comportent un transistor (32) ayant un canal branché en parallèle avec ledit transducteur (22) et répondant audit deuxième état dudit signal de commande (Sc) pour court-circuiter ledit transducteur (22).

## Patentansprüche

1. Vorrichtung mit einem piezoelektrischen Wandler (22), mit einer Versorgungsquelle elektrischer Energie (23), die eine erste Spannung erzeugt, und mit Steuermitteln, die auf einen ersten Zustand eines Steuersignals (Sc) ansprechen, um an den Wandler (22) eine Steuergleichspannung anzulegen, und bei einem zweiten Zustand des Steuersignals (Sc) den Wandler (22) kurzzuschließen, welche Steuermittel Spannungserhöhungsmittel umfassen, die auf die erste Spannung reagieren, um die Steuergleichspannung zu erzeugen, und die eine Spule (25), eine Diode (26) und einen in Serie in dieser Reihenfolge geschalteten Kondensator umfassen, angeschlossen zwischen den Klemmen (23a, 23b) der Speisequelle (23), und mit Mitteln (27, 28) zum alternierenden Etablieren bzw. Unterdrücken eines Kurzschlußes an den Klemmen des von der Diode (26) und dem Kondensator gebildeten Kreises, dadurch gekennzeichnet, daß der Kondensator von dem Wandler (22) gebildet ist, und daß die Spannungserhöhungsmittel im übrigen auf den ersten Zustand des Steuersignals (Sc) reagieren, um die Steuergleichspannung zu erzeugen.

2. Vorrichtung nach Anspruch 1, dadurch gekennzeichnet, daß die Spannungserhöhungsmittel ferner umfassen:
- Oszillatormittel (28), die auf das Steuersignal (Sc) und auf die Steuerspannung reagieren, um ein Ausgangssignal zu erzeugen, das alternierend einen ersten und einen zweiten Zustand annimmt, wenn das Steuersignal (Sc) in seinem ersten Zustand ist und die Steuerspannung kleiner ist als eine Referenzspannung, und permanent in seinem zweiten Zustand bleibt, wenn das Steuersignal in seinem zweiten Zustand ist, oder die Steuerspannung höher ist als die Referenzspannung, und
- einen Transistor (27) mit einem Kanal, der parallel der von der Diode (26) und dem Kondensator gebildeten Schaltung liegt und auf den ersten Zustand des Ausgangssignals reagiert, um den Kurzschluß zu etablieren und auf den zweiten Zustand des Ausgangssignals reagiert, um den Kurzschluß zu unterdrücken.

3. Vorrichtung nach Anspruch 1, dadurch gekennzeichnet, daß die Steuermittel einen Transistor (32) umfassen, dessen Kanal parallel zu dem Wandler (22) liegt, und der auf den zweiten Zustand des Steuersignals (Sc) reagiert, um den Wandler (22) kurzzuschließen.

## Claims

1. Device comprising a piezoelectric transducer (22), an electric power supply source (23) producing a first voltage and control means responsive to a first state of a control signal (Sc) for applying to said transducer (22) a continuous control voltage and responsive to a second state of said control signal (Sc) for short-circuiting said transducer (22), said control means including voltage increasing means responsive to said first voltage to produce said continuous control voltage and including a coil (25), a diode (26) and a capacitor which are connected in series, in that order, across the terminals (23a, 23b) of said supply source (23), and means (27, 28) for alternately producing and cancelling a short-circuit across the terminals of the circuit formed by said diode (26) and said capacitor, characterized in that said capacitor is constituted by said transducer (22), and that said voltage increasing means are further responsive to said first state of said control signal (Sc) to produce said continuous control voltage.

2. Device according to claim 1, characterized in that said voltage increasing means further comprise :
- oscillating means (28) responsive to said control signal (Sc) and to said control voltage for producing an output signal which has alternating first and second states when said control signal (Sc) is in its first state and when said control voltage is less than a reference voltage, and which stays permanently in its second state when said control signal is in its second state or when said control voltage is greater than said reference voltage; and
- a transistor (27) having a channel connected in parallel to said circuit formed by said diode (26) and said capacitor and responsive to said first state of said output signal for establishing said short-circuit and responsive to said second state of said output signal for cancelling said short-circuit.

3. Device according to claim 1, characterized in that said control means include a transistor (32) having a channel connected in parallel to said transducer (22) and being responsive to said second state of said control signal (Sc) for short-circuiting said transducer (22).
